# EUROPEAN PATENT APPLICATION

(11) **EP 4 626 171 A1**
(43) Date of publication of application: **01.10.2025**
(21) Application number: 25159214.3
(22) Date of filing: 20.02.2025
(51) Int. Cl.: H10D 64/23, H10D 30/62, H10D 30/67

(54) **BACKSIDE-PATTERNED FIN ISOLATION STRUCTURES BETWEEN SEMICONDUCTOR DEVICES**

(30) Priority: 29.03.2024 US 202418621785
(71) Applicant: Intel Corporation, Santa Clara, CA 95054 (US)
(72) Inventor: ZHANG, Kan, Hillsboro, OR 97123 (US); CHU, Tao, Portland, OR 97229 (US); XU, Guowei, Portland, OR 97229 (US); MURTHY, Anand, Portland, OR 97229 (US); ZHANG, Yang, Rio Rancho, NM 87124 (US); CHAO, Robin, Portland, OR 97209 (US); HUNG, Ting-Hsiang, Beaverton, OR 97007 (US); ZHANG, Feng, Portland, OR 97229 (US); LIN, Chia-Ching, Portland, OR 97229 (US); YEUNG, Chun Wing, Portland, OR 97229 (US); LU, Yuanfang, Hillsboro, OR 97123 (US); LIN, Chung-Hsun, Portland, OR 97229 (US)
(74) Representative: HGF

(57) **Abstract**

Techniques are provided to form an integrated circuit having fin isolation structures patterned from the backside of the structure. FETs (field effect transistors) each includes semiconductor material extending colinearly between source and drain regions, and gate structures extending around the semiconductor material of each FET. A fin isolation structure may extend between the FETs to provide electrical isolation between the FETs. The fin isolation structure may include one or more dielectric materials that are deposited within a trench and patterned from the backside of the structure to avoid damaging topside features of the FETs. N-channel FETs may be separated by a fin isolation structure having a high-k dielectric liner and a low-k dielectric fill, and P-channel FETs may be separated by a fin isolation structure having a high-k dielectric liner and a dielectric fill that includes high-k and low-k dielectric materials.

## Description

### BACKGROUND

As integrated circuits continue to scale downward in size, a number of challenges arise. For instance, reducing the size of memory and logic cells within the interconnect structure is becoming increasingly more difficult, as is reducing device spacing at the device layer. Maintaining a certain level of quality among the various transistor elements can be a challenge due to the number of different fabrication processes they may be subjected to. Accordingly, there remain a number of non-trivial challenges with respect to forming such high-density semiconductor devices.

### BRIEF DESCRIPTION OF THE DRAWINGS

Figures 1A and 1B are cross-sectional views of different semiconductor devices in an integrated circuit that includes backside-patterned fin isolation structures between semiconductor devices, in accordance with an embodiment of the present disclosure.
Figures 2A and 2B are cross-sectional views that illustrate one stage in an example process for forming an integrated circuit configured with backside-patterned fin isolation structures between semiconductor devices, in accordance with an embodiment of the present disclosure.
Figures 3A and 3B are cross-sectional views that illustrate another stage in the example process for forming an integrated circuit configured with backside-patterned fin isolation structures between semiconductor devices, in accordance with an embodiment of the present disclosure.
Figures 4A and 4B are cross-sectional views that illustrate another stage in the example process for forming an integrated circuit configured with backside-patterned fin isolation structures between semiconductor devices, in accordance with an embodiment of the present disclosure.
Figures 5A and 5B are cross-sectional views that illustrate another stage in the example process for forming an integrated circuit configured with backside-patterned fin isolation structures between semiconductor devices, in accordance with an embodiment of the present disclosure.
Figures 6A and 6B are cross-sectional views that illustrate another stage in the example process for forming an integrated circuit configured with backside-patterned fin isolation structures between semiconductor devices, in accordance with an embodiment of the present disclosure.
Figures 7A and 7B are cross-sectional views that illustrate another stage in the example process for forming an integrated circuit configured with backside-patterned fin isolation structures between semiconductor devices, in accordance with an embodiment of the present disclosure.
Figures 8A and 8B are cross-sectional views that illustrate another stage in the example process for forming an integrated circuit configured with backside-patterned fin isolation structures between semiconductor devices, in accordance with an embodiment of the present disclosure.
Figures 9A and 9B are cross-sectional views that illustrate another stage in the example process for forming an integrated circuit configured with backside-patterned fin isolation structures between semiconductor devices, in accordance with an embodiment of the present disclosure.
Figures 10A and 10B are cross-sectional views that illustrate another stage in the example process for forming an integrated circuit configured with backside-patterned fin isolation structures between semiconductor devices, in accordance with an embodiment of the present disclosure.
Figures 11A and 11B are cross-sectional views that illustrate another stage in the example process for forming an integrated circuit configured with backside-patterned fin isolation structures between semiconductor devices, in accordance with an embodiment of the present disclosure.
Figures 12A and 12B are cross-sectional views that illustrate another stage in the example process for forming an integrated circuit configured with backside-patterned fin isolation structures between semiconductor devices, in accordance with an embodiment of the present disclosure.
Figures 13A and 13B are cross-sectional views that illustrate another stage in the example process for forming an integrated circuit configured with backside-patterned fin isolation structures between semiconductor devices, in accordance with an embodiment of the present disclosure.
Figures 14A and 14B are cross-sectional views that illustrate another stage in the example process for forming an integrated circuit configured with backside-patterned fin isolation structures between semiconductor devices, in accordance with an embodiment of the present disclosure.
Figures 15A and 15B are cross-sectional views that illustrate another stage in the example process for forming an integrated circuit configured with backside-patterned fin isolation structures between semiconductor devices, in accordance with an embodiment of the present disclosure.
Figure 16 illustrates a cross-sectional view of a chip package containing one or more semiconductor dies, in accordance with some embodiments of the present disclosure.
Figure 17 is a flowchart of a fabrication process for semiconductor devices having a backside fin isolation structure between them, in accordance with an embodiment of the present disclosure.
Figure 18 illustrates a computing system including one or more integrated circuits, as variously described herein, in accordance with an embodiment of the present disclosure.

Although the following Detailed Description will proceed with reference being made to illustrative embodiments, many alternatives, modifications, and variations thereof will be apparent in light of this disclosure. As will be further appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used.

### DETAILED DESCRIPTION

Techniques are provided herein to form an integrated circuit having fin isolation structures patterned from the backside of the structure. The techniques can be used in any number of integrated circuit applications and are particularly useful with respect to logic and memory cells, such as those cells that use finFETs or gate-all-around transistors (e.g., ribbonFETs and nanowire FETs) or forksheet transistors. In one such example, FETs (field effect transistors) each includes semiconductor material extending colinearly in a first direction between source and drain regions, and gate structures extending in a second direction around the semiconductor material of each FET. The semiconductor material of each FET may be a fin or any number of nanowires (or nanoribbons or nanosheets, as the case may be). A fin isolation structure may extend along the second direction between the FETs to provide electrical isolation between the FETs. The fin isolation structure may include one or more dielectric materials that are deposited within a trench and patterned from the backside of the structure, which helps avoid damaging topside features of the FETs. According to some embodiments, N-channel FETs are separated by a fin isolation structure having a high-k dielectric liner and a low-k dielectric fill, and P-channel FETs are separated by a fin isolation structure having a high-k dielectric liner and a dielectric fill that includes both high-k and low-k dielectric materials. The different dielectric materials used between N-channel and P-channel devices impart different strain on the devices to improve performance. Numerous variations and embodiments will be apparent in light of this disclosure.

### General Overview

As previously noted above, there remain a number of non-trivial challenges with respect to integrated circuit fabrication. In more detail, isolating semiconductor devices from one another is important to provide desired circuit and logic arrangements. Several different isolation structures and techniques are used to provide electrical isolation. One such structure is a fin isolation structure that electrically isolates different portions of a semiconductor fin. Since several devices can be formed along the length of a single fin, fin isolation structures can be used to isolate devices along the fin. The fin isolation structures may include dielectric material formed within a trench that cuts through a given fin and runs perpendicular to the length of the fin. However, many of the processes used to form the isolation structures can damage other topside semiconductor features, such as spacer structures, which leads to decreased device performance or inoperability.

Thus, and in accordance with an embodiment of the present disclosure, techniques are provided herein to pattern the dielectric material of the fin isolation structures form the backside of the substrate to avoid performing etching processes to the topside that may damage other transistor elements. In some embodiments, the fin isolation structures are formed by filling an opening between semiconductor devices with one or more dielectric materials. The opening may be a trench-like opening that cuts across the height of a fin (or the semiconductor material from the fin) in order to isolate semiconductor devices on either side of the opening. One or more of the dielectric materials within the opening may then be exposed and patterned from the backside of the structure to avoid damaging topside transistor features.

According to some embodiments, the dielectric material within the opening may be different depending on whether the adjacent semiconductor devices are n-channel devices or p-channel devices. In the case of n-channel devices, the fin isolation structure may include a high-k dielectric liner with a low-k dielectric fill along an entire height of the fin. In the case of p-channel devices, the fin isolation structure may include a high-k dielectric liner and a dielectric fill that includes both low-k and a high-k dielectric material. In some examples, the low-k dielectric material may be present near the top end of the fin isolation structure, above a topmost surface of the source or drain regions and/or above a topmost surface of the semiconductor region of the adjacent semiconductor devices. High-k dielectric materials may include dielectric materials with a dielectric constant of 6.0 or greater, such as silicon nitride, while low-k dielectric materials may include dielectric materials with a dielectric constant of less than 5.0, such as silicon dioxide. Using fin isolation structures with different dielectric material compositions can impart a different strain on the adjacent devices.

According to an embodiment, an integrated circuit includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, and a dielectric structure extending in the second direction between the first source or drain region and the second source or drain region and extending in a third direction along an entire height of the first source or drain region and the second source or drain region. The second semiconductor region is aligned with the first semiconductor region along the first direction. The dielectric structure extends to a depth below a bottommost surface of the first and second source or drain regions.

According to another embodiment, an integrated circuit includes a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, and a dielectric structure extending in the second direction between the first source or drain region and the second source or drain region and extending in a third direction along an entire height of the first source or drain region and the second source or drain region. The second semiconductor region is aligned with the first semiconductor region along the first direction. The dielectric structure includes a first dielectric material and a second dielectric material on the first dielectric material. The second dielectric material is a plug (body) of material above a topmost surface of the first source or drain region and the second source or drain region. The first dielectric material wraps around the second dielectric material and fills a region of the dielectric structure below the second dielectric material.

According to another embodiment, an electronic device includes a chip package having one or more dies. At least one of the one or more dies includes a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, and a dielectric structure extending in the second direction between the first source or drain region and the second source or drain region, and extending in a third direction along an entire height of the first source or drain region and the second source or drain region. The second semiconductor region is aligned with the first semiconductor region along the first direction. The first and second source or drain regions each extend to a first depth below a bottommost surface of the first and second gate structures, and the dielectric structure extends to a second depth below the bottommost surface of the first and second gate structures. The second depth is greater than the first depth.

According to an embodiment, a method of forming an integrated circuit includes forming fins comprising semiconductor material where the fins extend above a substrate and each extend in line with one another along a first direction; forming a dielectric layer around a base portion of the fins; forming source or drain regions at the ends of each of the fins; forming a recess through a given fin, wherein the recess extends below a bottommost surface of the dielectric layer; forming a first dielectric material on the sidewalls of the recess; forming a second dielectric material on the first dielectric material within the recess, the first and second dielectric materials together forming a dielectric structure; forming gate electrodes extending over the semiconductor material of the fins in a second direction different from the first direction; removing a portion of the substrate from the backside and exposing a bottom surface of the dielectric structure; recessing or removing the second dielectric material from the backside to form a backside recess; and filling the backside recess with a third dielectric material.

The techniques can be used with any type of planar or non-planar transistors, including finFETs (sometimes called double-gate transistors, or tri-gate transistors), or nanowire and nanoribbon transistors (sometimes called gate-all-around transistors), or forksheet transistors, to name a few examples. The source and drain regions can be, for example, epitaxial regions that are deposited during an etch-and-replace source/drain forming process. The dopant-type in the source and drain regions will depend on the polarity of the corresponding transistor. The gate structure can be implemented with a gate-first process or a gate-last process (sometimes called a replacement metal gate, or RMG, process), or any other gate formation process. Any number of semiconductor materials can be used in forming the transistors, such as group IV materials (e.g., silicon, germanium, silicon germanium) or group III-V materials (e.g., gallium arsenide, indium gallium arsenide).

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For instance, in some example embodiments, such tools may indicate the presence of one or more fin isolation structures (e.g., dielectric walls) between semiconductor devices and extending in the same lengthwise direction as the gate structures, that also extend in a third direction (e.g., along the height of the devices) beneath a bottommost surface of the source or drain regions. In some examples, the fin isolation structures extend through an entire thickness of a base dielectric layer beneath the semiconductor devices (e.g., to a first backside interconnect layer). In some embodiments, such imaging tools may be used to observe the presence of a plug (body) of low-k dielectric material within a given fin isolation structure that is above a topmost surface of the source or drain regions or above a topmost surface of the semiconductor regions of the adjacent devices. In some such cases, the plug may appear to be laterally surrounded by a larger body of high-k dielectric material that may also be under the plug in some locations.

It should be readily understood that the meaning of "above" and "over" in the present disclosure should be interpreted in the broadest manner such that "above" and "over" not only mean "directly on" something but also include the meaning of over something with an intermediate feature or a layer therebetween. Further, spatially relative terms, such as "beneath," "below," "lower," "above," "upper," "top," "bottom," and the like, may be used herein for ease of description to describe one element or feature's relationship to another element (s) or feature (s) as illustrated in the figures. The spatially relative terms are intended to encompass different orientations of the device in use or operation in addition to the orientation depicted in the figures. The apparatus may be otherwise oriented (rotated 90 degrees or at other orientations) and the spatially relative descriptors used herein may likewise be interpreted accordingly.

As used herein, the term "layer" refers to a material portion including a region with a thickness. A monolayer is a layer that consists of a single layer of atoms of a given material. A layer can extend over the entirety of an underlying or overlying structure, or may have an extent less than the extent of an underlying or overlying structure. Further, a layer can be a region of a homogeneous or inhomogeneous continuous structure, with the layer having a thickness less than the thickness of the continuous structure. For example, a layer can be located between any pair of horizontal planes between, or at, a top surface and a bottom surface of the continuous structure. A layer can extend horizontally, vertically, and/or along a tapered surface. A layer can be conformal to a given surface (whether flat or curvilinear) with a relatively uniform thickness across the entire layer.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

### Architecture

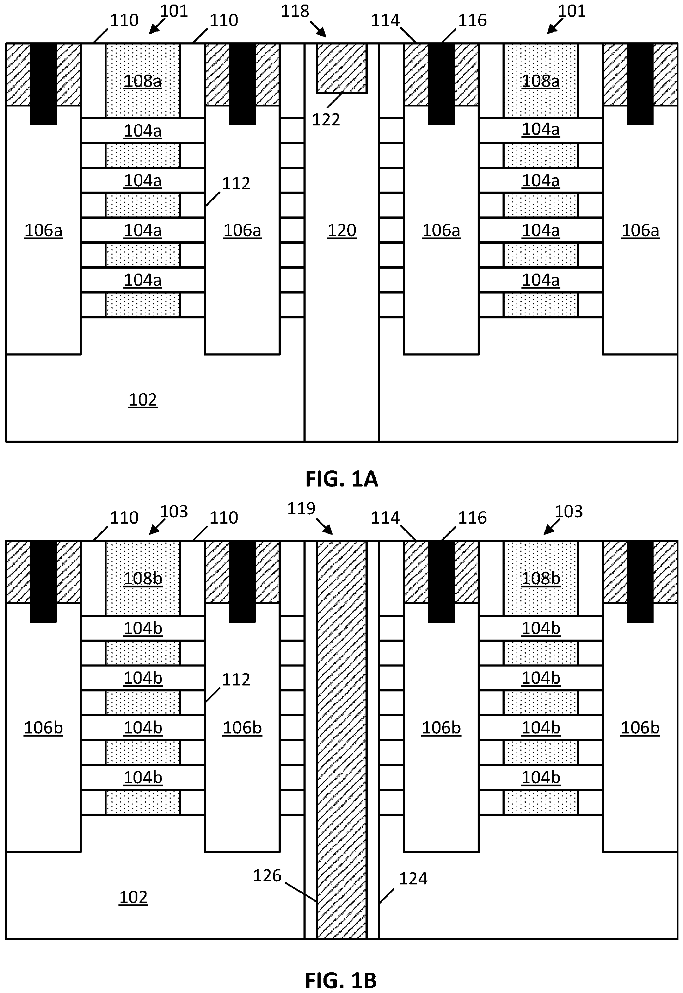

Figure 1A is a cross-section view taken through semiconductor devices 101 along a 'fin' direction that illustrates the semiconductor bodies extending between source or drain regions of each of the semiconductor devices, in accordance with an embodiment of the present disclosure. Figure 1B illustrates a cross-section view taken through different semiconductor devices 103 on the same die as semiconductor devices 101. Semiconductor devices 103 may be further along the same fin as semiconductor devices 101, or may be part of a different fin extending parallel to the fin of semiconductor devices 101. Each of the semiconductor devices may be, for instance, non-planar metal oxide semiconductor (MOS) transistors, such as tri-gate (e.g., finFET) or gate-all-around (GAA) transistors, although other transistor topologies and types could also benefit from the techniques provided herein. The examples herein illustrate semiconductor devices with a GAA structure (e.g., having nanoribbons, nanowires, or nanosheets that extend between source and drain regions). Other examples may have a forksheet structure having a p-type device and an n-type device separated by a dielectric spine or structure. According to some embodiments, semiconductor devices 101 are p-channel devices (e.g., PMOS) and semiconductor devices 103 are n-channel devices (e.g., NMOS).

The semiconductor material used in each of the semiconductor devices may be formed from or on a semiconductor substrate. According to some embodiments, the substrate is removed following the completion of all topside processing and is replaced with a base dielectric structure 102. Base dielectric structure 102 may represent any number of dielectric layers and/or materials. In some examples, base dielectric structure 102 includes one or more layers of silicon dioxide.

The one or more semiconductor regions of the devices may include fins that can be, for example, native to the substrate (formed from the substrate itself), such as silicon fins etched from a bulk silicon substrate. Alternatively, the fins can be formed of material deposited onto the substrate. In one such example case, a blanket layer of SiGe can be deposited onto a silicon substrate, and then patterned and etched to form a plurality of SiGe fins extending from that substrate. In still other embodiments, the fins include alternating layers of material (e.g., alternating layers of silicon and SiGe) that facilitates forming of nanowires and nanoribbons and nanosheets during a gate forming process where one type of the alternating layers is selectively etched away so as to liberate the other type of alternating layers within the channel region, so that a gate-all-around process or a forksheet gate process can then be carried out. Again, the alternating layers can be blanket deposited and then etched into fins or deposited into fin-shaped trenches, in some examples.

Each semiconductor device 101 includes one or more semiconductor regions (also called channel regions), such as one or more nanoribbons 104a extending between epitaxial source or drain regions 106a in the first direction. Similarly, each semiconductor device 103 includes one or more semiconductor nanoribbons 104b extending between epitaxial source or drain regions 106b in the first direction. First gate structures 108a extend over nanoribbons 104a of semiconductor devices 101 in a second direction (e.g., into and out of the page) to form the transistor gates of semiconductor devices 101 and second gate structures 108b extend over nanoribbons 104b of semiconductor devices 103 in the second direction to form the transistor gates of semiconductor devices 103.

Any of source or drain regions 106a/106b may act as either a source region or a drain region, depending on the application and dopant profile. Any semiconductor materials suitable for source and drain regions can be used (e.g., group IV and group III-V semiconductor materials) for any of the illustrated source or drains regions 106a/106b. In any such cases, the composition and doping of source or drain regions 106a and 106b may be the same or different, depending on the polarity of the transistors. In an example, semiconductor devices 101 are p-channel devices having a high concentration of p-type dopants in the associated source or drain regions 106a, and semiconductor devices 103 are n-channel devices having a high concentration of n-type dopants in the associated source or drain regions 106b. Example p-type dopants include boron and example n-type dopants include phosphorous or arsenic. Any number of source and drain configurations and materials can be used. In some examples, source or drain regions 106b include silicon germanium doped with boron and source or drain regions 106a include silicon doped with phosphorous.

The gate structures 108a/108b may each include a gate electrode that is made up of a conductive fill and one or more metal workfunction layers, according to some embodiments. The gate structures 108a/108b also include a gate dielectric that may represent any number of dielectric layers. The conductive fill may include any sufficiently conductive material such as a metal, metal alloy, or doped polysilicon. In some examples, the conductive fill includes tungsten (W), although other metals or conductive materials may be used, such as aluminum (Al), molybdenum (Mo), ruthenium (Ru), cobalt (Co), or doped polysilicon. In some embodiments, semiconductor devices 101 are p-channel devices having gate structures 108a with one or more workfunction layers of molybdenum nitride (MoN). Other metal workfunction layers of p-channel devices can include tantalum nitride (TaN) and titanium nitride (TiN). In some embodiments, semiconductor devices 103 are n-channel devices having gate structures 108b with one or more workfunction layers of tungsten. Other metal workfunction layers of n-channel devices can include tantalum nitride (TaN).

The gate dielectric of each gate structure 108a/108b may include any suitable gate dielectric material(s). In some embodiments, the gate dielectric includes a layer of native oxide material (e.g., silicon dioxide germanium dioxide, or SiGe oxide) on nanoribbons 104a/104b, and a layer of high-k dielectric material (e.g., hafnium oxide or aluminum oxide) on the native oxide. According to some embodiments, spacer structures 110 and inner spacers 112 are present along the sidewalls of gate structures 108a/108b. Spacer structures 110 and inner spacers 112 may be any suitable dielectric material, such as silicon nitride, and provide separation between a given gate structure 108a/108b and the adjacent source or drain region 106a/106b. Inner spacers 112 may separate adjacent nanoribbons 104a/104b from one another along a third direction (e.g., a vertical direction).

According to some embodiments, a dielectric fill 114 may be present over the source or drain regions 106a/106b within the corresponding source/drain trenches of semiconductor devices 101 and 103. A top surface of dielectric fill 114 may be substantially co-planar with a top surface of spacer structures 110. Dielectric fill 114 may include any suitable dielectric material, such as silicon dioxide, in some examples.

According to some embodiments, conductive contacts 116 are provided through dielectric fill 114 and contacting a top portion of source or drain regions 106a/106b. Conductive contacts 116 can include any suitable conductive material, such as tungsten, molybdenum, ruthenium, cobalt, or other metals. Conductive contacts 116 may be formed during the same metal deposition process(es) such that they all include the same conductive material.

According to some embodiments, semiconductor devices 101 are electrically isolated by a first fin isolation structure 118 extending along the second direction between semiconductor devices 101, and semiconductor devices 103 are electrically isolated by a second fin isolation structure 119 extending along the second direction between semiconductor devices 103. According to some embodiments, first fin isolation structure 118 and second fin isolation structure 119 are partially formed from the backside of the integrated circuit, such that bottom surfaces of first fin isolation structure 118 and second fin isolation structure 119 are substantially coplanar with a bottom surface of base dielectric structure 102. The backside processing of first fin isolation structure 118 and second fin isolation structure 119 also results in both first fin isolation structure 118 and second fin isolation structure 119 extending below the bottommost surfaces of source or drain regions 106a/106b. First fin isolation structure 118 extends in the third direction along at least an entire height of the adjacent source or drain regions 106a, and second fin isolation structure 119 extends in the third direction along at least an entire height of the adjacent source or drain regions 106b.

According to some embodiments, first fin isolation structure 118 includes a first dielectric material 120 and a second dielectric material 122. First dielectric material 120 may be a high-k dielectric material, such as silicon nitride, while second dielectric material 122 is a low-k dielectric material, such as silicon dioxide. According to some embodiments, first dielectric material 120 fills a region of first fin isolation structure 118 that is below second dielectric material 122 and is also along the sides of second dielectric material 122. In this way, second dielectric material 122 acts like a plug of dielectric material at the top end of first fin isolation structure 118. In some examples, a top surface of second dielectric material 122 is substantially coplanar with a top surface of first fin isolation structure 118. A bottommost surface of second dielectric material 122 may be higher than a topmost surface of the adjacent source or drain regions 106a or higher than a topmost surface of nanoribbons 104a. According to some embodiments, the dielectric material arrangement of first fin isolation structure 118 imparts a first beneficial strain on the adjacent p-channel semiconductor devices 101.

According to some embodiments, second fin isolation structure 119 includes a dielectric liner 124 and a dielectric fill 126. Dielectric liner 124 may be a high-k dielectric material, such as silicon nitride, while dielectric fill 126 is a low-k dielectric material, such as silicon dioxide. According to some embodiments, dielectric liner 124 extends along the sidewalls of second fin isolation structure 119 and dielectric fill 126 occupies a remaining volume of second fin isolation structure 119. According to some embodiments, dielectric liner 124 is also a part of first dielectric material 120. Dielectric liner 124 may have the same material composition as first dielectric material 120, and dielectric fill 126 may have the same material composition as second dielectric material 122. According to some embodiments, the dielectric material arrangement of second fin isolation structure 119 imparts a second beneficial strain on the adjacent n-channel semiconductor devices 103. The second strain is different from the first strain imparted by first fin isolation structure 118 on the adjacent p-channel semiconductor devices 101.

### Fabrication Methodology

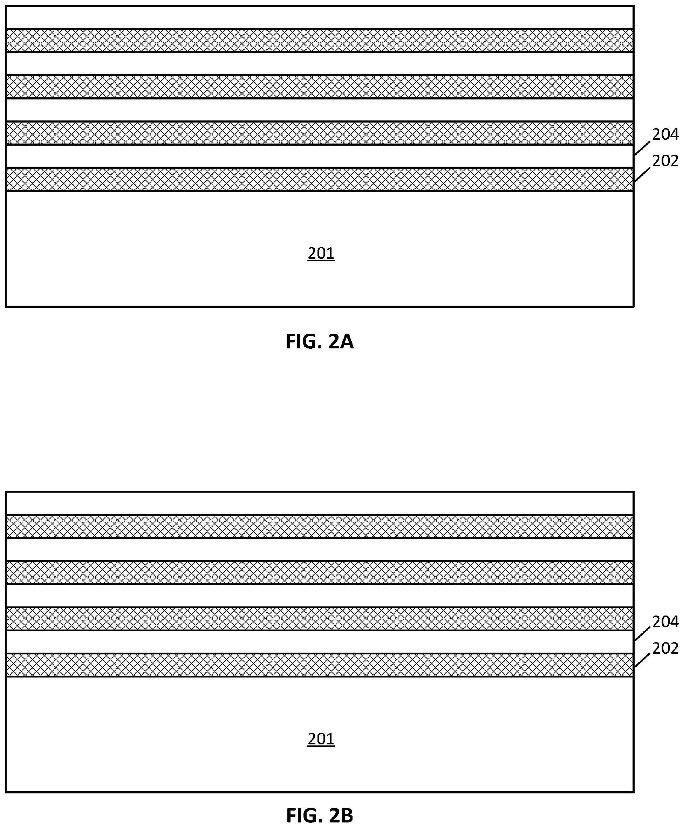

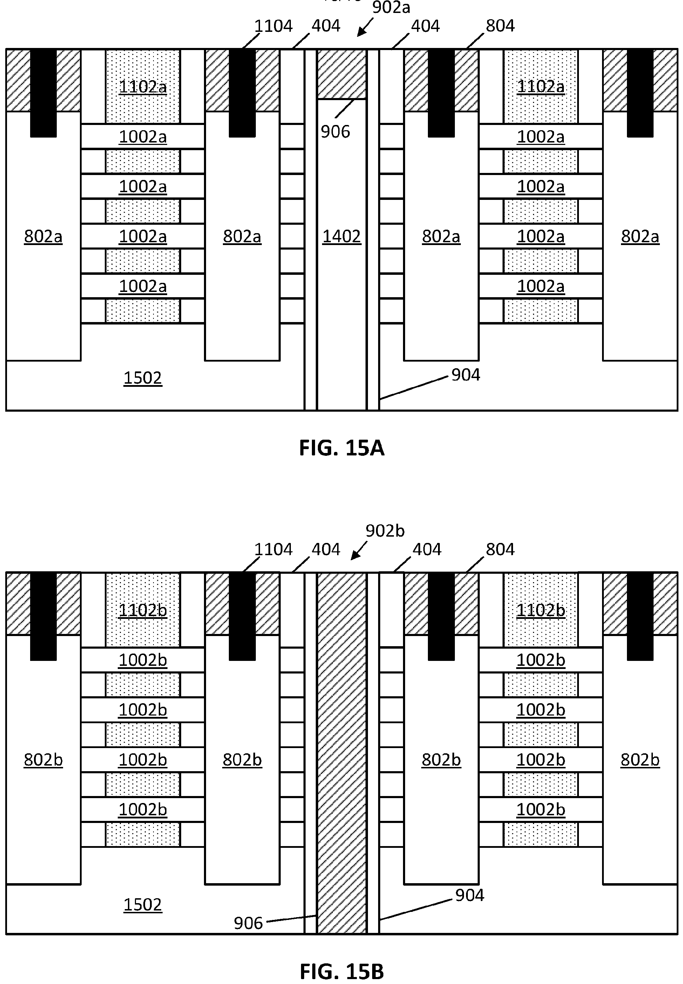

Figures 2A - 15A and 2B - 15B include cross-sectional views that collectively illustrate an example process for forming an integrated circuit configured with backside-patterned fin isolation structures, in accordance with an embodiment of the present disclosure. Figures 2A - 15A represent a similar cross-sectional view as that of Figure 1A across a series of semiconductor devices, while Figures 2B - 15B represent a similar cross-sectional view as that of Figure 1B across a series of different semiconductor devices. Each set of figures sharing the same letter shows an example structure that results from the process flow up to that point in time, so the depicted structure evolves as the process flow continues, culminating in the structure shown in Figures 15A - 15B, which is similar to the structure shown in Figures 1A and 1B. Such a structure may be part of an overall integrated circuit (e.g., such as a processor or memory chip) that includes, for example, digital logic cells and/or memory cells and analog mixed signal circuitry. Thus, the illustrated integrated circuit structure may be part of a larger integrated circuit that includes other integrated circuitry not depicted. Example materials and process parameters are given, but other materials and process parameters may be used as well, as will be appreciated in light of this disclosure.

Figures 2A and 2B each illustrates a cross-sectional view taken through a substrate 201 having a series of material layers formed over substrate 201, according to an embodiment of the present disclosure. Alternating material layers may be deposited over substrate 201 including sacrificial layers 202 alternating with semiconductor layers 204. The alternating layers are used to form GAA transistor structures. Any number of alternating sacrificial layers 202 and semiconductor layers 204 may be deposited over substrate 201.

Substrate 201 can be, for example, a bulk substrate including group IV semiconductor material (such as silicon, germanium, or SiGe), group III-V semiconductor material (such as gallium arsenide, indium gallium arsenide, or indium phosphide), and/or any other suitable material upon which transistors can be formed. Alternatively, substrate 201 can be a semiconductor-on-insulator substrate having a desired semiconductor layer over a buried insulator layer (e.g., silicon over silicon dioxide). Alternatively, substrate 201 can be a multilayer substrate or superlattice suitable for forming nanowires or nanoribbons (e.g., alternating layers of silicon and SiGe, or alternating layers indium gallium arsenide and indium phosphide). Any number of substrates can be used.

According to some embodiments, semiconductor layers 204 have a different material composition than sacrificial layers 202. In some embodiments, semiconductor layers 204 include a semiconductor material suitable for use as a nanoribbon such as silicon (Si), SiGe, germanium, or III-V materials like indium phosphide (InP) or gallium arsenide (GaAs). Sacrificial layers 202 include a material that can be selectively removed relative to semiconductor layers 204. In some examples, for instance, semiconductor layers 204 are silicon and sacrificial layers 202 are SiGe, or vice-versa. In some other examples where SiGe is used in each of semiconductor layers 204 and in sacrificial layers 202, the germanium concentration is different between semiconductor layers 204 and sacrificial layers 202, so as to allow for etch selectivity. For example, semiconductor layers 204 may include a higher germanium content compared to sacrificial layers 202.

While dimensions can vary from one example embodiment to the next, the thickness of each semiconductor layer 204 may be between about 5 nm and about 20 nm, in some examples. In some embodiments, the thickness of each semiconductor layer 204 is substantially the same (e.g., within 1-2 nm). The thickness of each of sacrificial layers 202 may be about the same as the thickness of each semiconductor layer 204 (e.g., about 5-20 nm). Each of semiconductor layers 204 and sacrificial layers 202 may be deposited using any material deposition technique, such as chemical vapor deposition (CVD), plasma-enhanced chemical vapor deposition (PECVD), physical vapor deposition (PVD), or atomic layer deposition (ALD), or epitaxial growth.

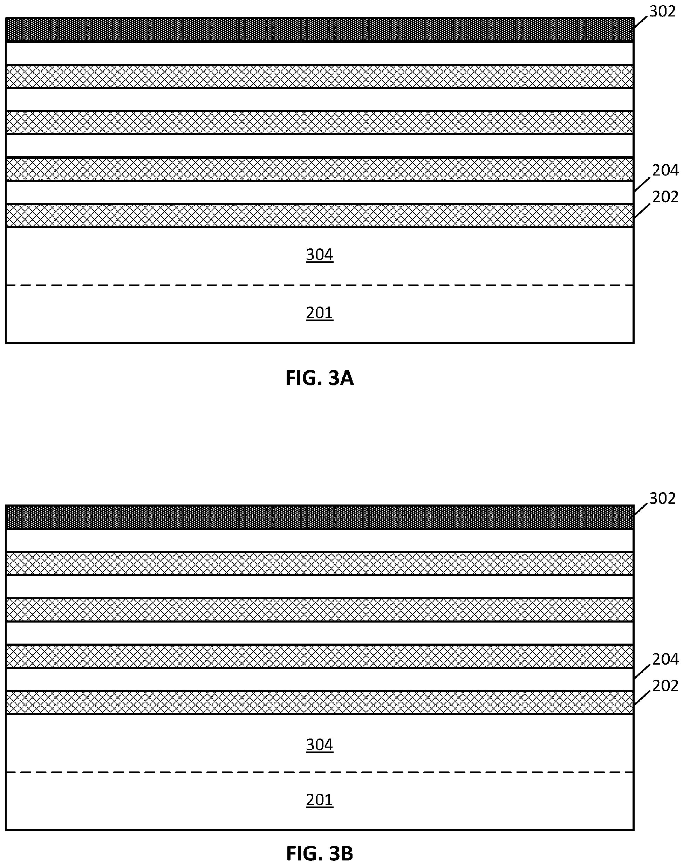

Figures 3A and 3B depict the cross-section views of the structure shown in Figures 2A and 2B, respectively, following the formation of a cap layer 302 and the subsequent formation of fins beneath cap layer 302, according to an embodiment. Cap layer 302 may be any suitable hard mask material such as a carbon hard mask (CHM) or silicon nitride. Cap layer 302 is patterned into rows to form corresponding rows of fins from the alternating layer stack of sacrificial layers 202 and semiconductor layers 204. Cap layer 302 extends along the top of each fin in a first direction. In some embodiments, Figures 3A and 3B illustrate different portions of the same fin (e.g., patterned under the same strip of cap layer 302). In some embodiments, Figures 3A and 3B illustrate portions of different parallel fins (e.g., under different parallel strips of cap layer 302).

According to some embodiments, an anisotropic etching process through the layer stack continues into at least a portion of substrate 201. Portions of substrate 201 beneath the fins are not etched and yield subfin regions 304. The etched portions of substrate 201 that are not under the fins may be filled with a dielectric fill that acts as shallow trench isolation (STI) between adjacent fins. The dielectric fill is not shown in these cross-sections as it extends in the first direction along the sides of subfin regions 304 that are into and out of the page. The dielectric fill may be any suitable dielectric material such as silicon dioxide. The subfin regions 304 represent remaining portions of substrate 201 flanked by the dielectric fill, according to some embodiments.

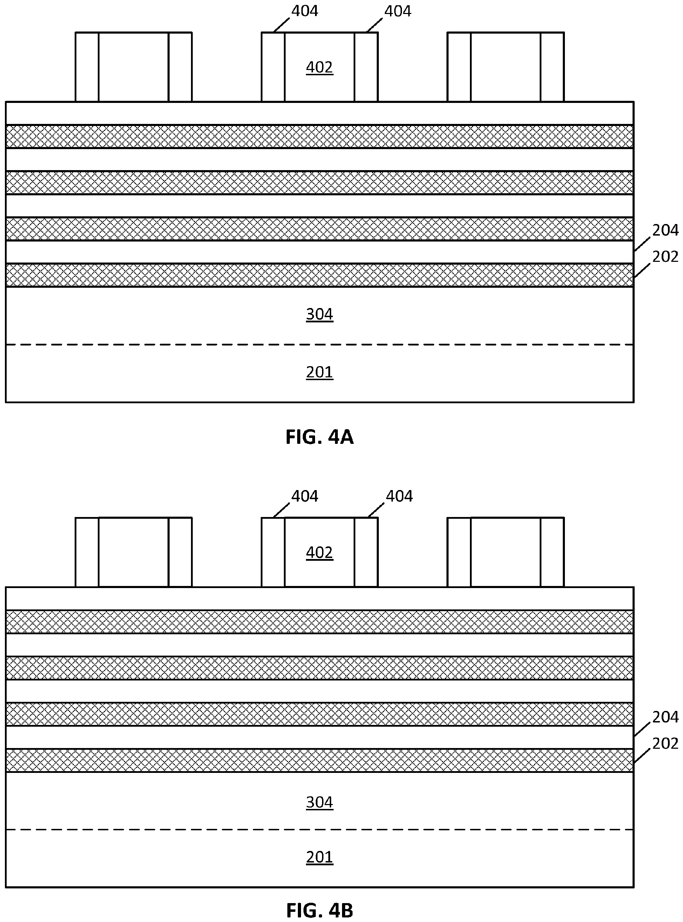

Figures 4A and 4B depict cross-section views of the structures shown in Figures 3A and 3B following the formation of sacrificial gates 402 and spacer structures 404, according to some embodiments. A gate masking layer may first be patterned in strips that extend orthogonally across each of the fins (e.g., in a second direction) in order to form corresponding sacrificial gates 402 in strips beneath the gate masking layers. Afterwards, the gate masking layers may be removed or may remain as a cap layer above each sacrificial gate 402. According to some embodiments, the sacrificial gate material is removed in all areas not protected by the gate masking layers. Sacrificial gate 402 may be any suitable material that can be selectively removed without damaging the semiconductor material of the fins. In some examples, sacrificial gate 402 includes polysilicon.

According to some embodiments, spacer structures 404 are formed along the sidewalls of sacrificial gates 402. Spacer structures 404 may be conformally deposited (e.g., CVD or ALD)_and then etched back or otherwise removed (e.g., via anisotropic or directional etch) from horizontal surfaces, such that spacer structures 404 remain mostly only on sidewalls of any exposed structures. The width of spacer structures 404 (along the first direction) may vary from one example to the next, but in some cases is in the range of 3 nm to 20 nm. According to some embodiments, spacer structures 404 may be any suitable dielectric material, such as silicon nitride, silicon carbon nitride, or silicon oxycarbonitride. In one such embodiment, spacer structures 404 comprise a nitride and the dielectric fill adjacent to subfin regions 304 comprises an oxide, so as to provide a degree of etch selectivity during final gate processing.

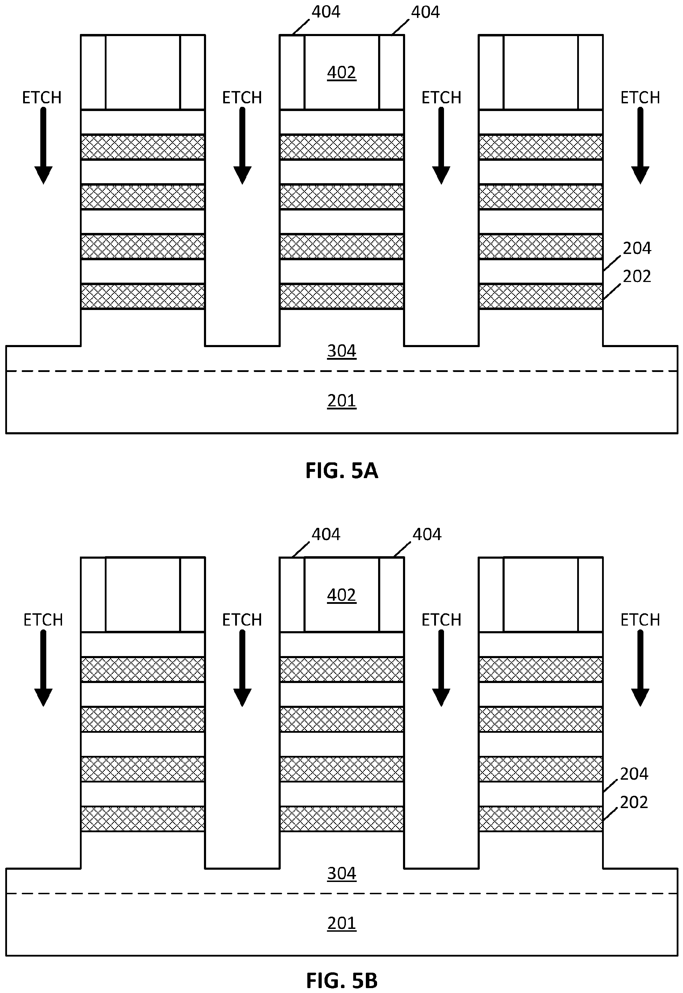

Figures 5A and 5B depict cross-section views of the structures shown in Figures 4A and 4B following the removal of exposed portions of the fins not protected by sacrificial gates 402 and spacer structures 404, according to some embodiments. The exposed fin portions may be removed using any anisotropic etching process, such as reactive ion etching (RIE) or other directional etch process. The removal of the exposed fin portions creates source or drain trenches that alternate with gate trenches (currently filled with sacrificial gates 402) along the first direction, according to some embodiments. In some embodiments, at least a portion of subfin regions 304 is also removed such that a top surface of subfin regions 304 is recessed below a top surface of the adjacent dielectric fill. The recessed area above subfin regions 304 may be filled with one or more dielectric materials.

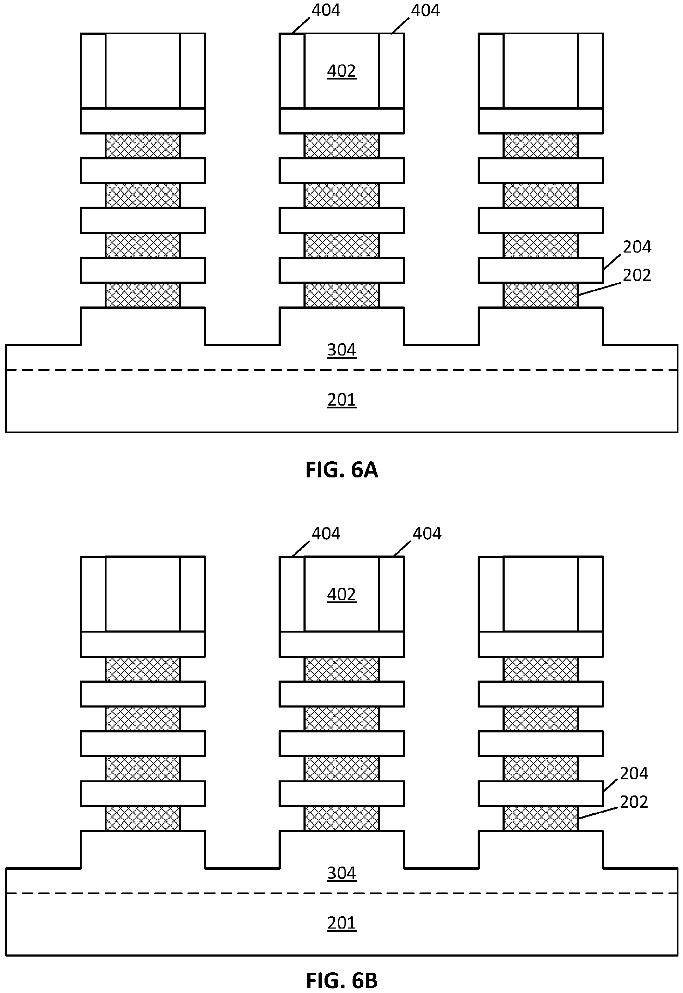

Figures 6A and 6B depict cross-section views of the structures shown in Figures 5A and 5B following the removal of portions of sacrificial layers 202, according to an embodiment of the present disclosure. An isotropic etching process may be used to selectively recess the exposed ends of each sacrificial layer 202 (e.g., while etching comparatively little of semiconductor layers 204).

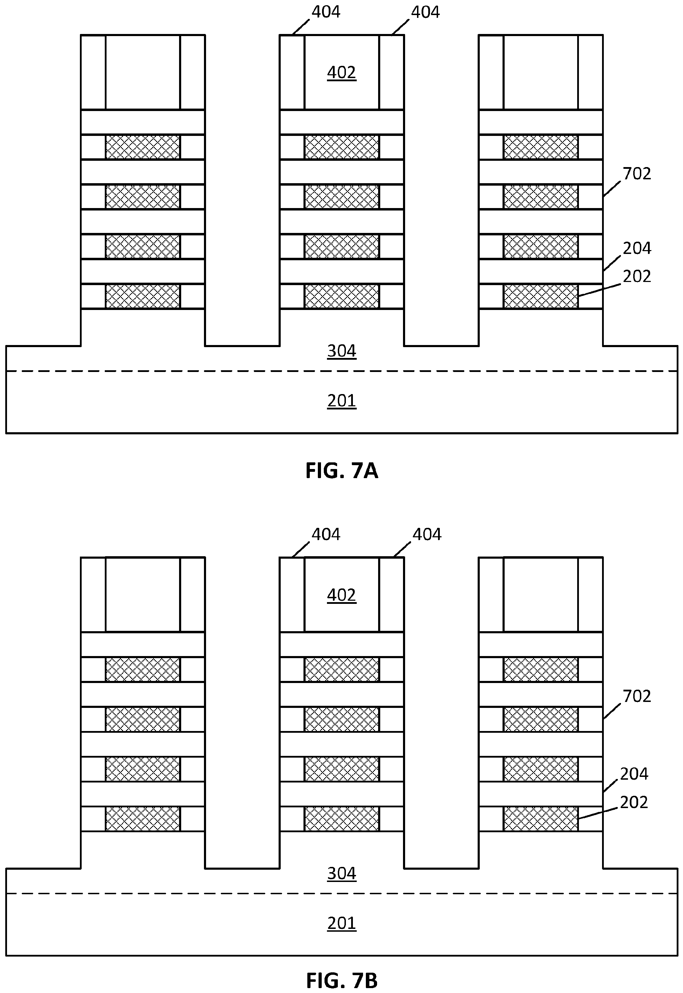

Figures 7A and 7B depict cross-section views of the structures shown in Figures 6A and 6B following the formation of internal spacers 702, according to an embodiment of the present disclosure. Internal spacers 702 may have a material composition that is similar to or the exact same as spacer structures 404. Accordingly, internal spacers 702 may be any suitable dielectric material that exhibits high etch selectively to semiconductor materials such as silicon and/or silicon germanium. Internal spacers 702 may be, for example, conformally deposited over the sides of the fin structure using a conformal deposition process like CVD or ALD and then etched back using an isotropic etching process to expose the ends of semiconductor layers 204. According to some embodiments, internal spacers 702 have a similar width (e.g., along the first direction) to spacer structures 404.

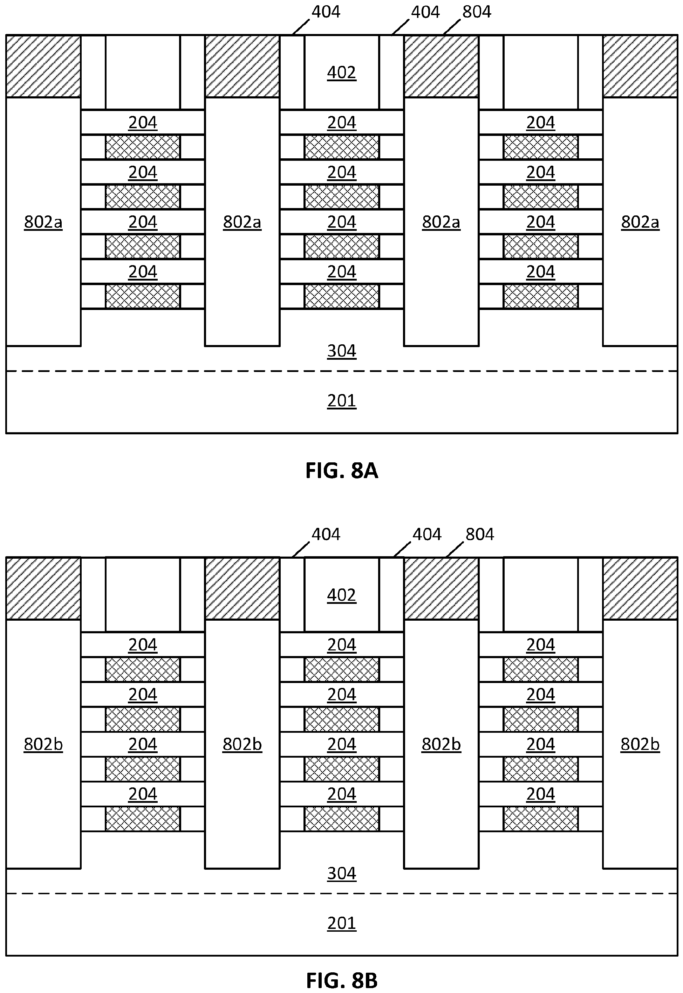

Figures 8A and 8B depict cross-section views of the structure shown in Figures 7A and 7B, respectively, following the formation of first source or drain regions 802a and second source or drain regions 802b within the source/drain trenches, according to some embodiments. Source or drain regions 802a/802b may be formed in the areas that had been previously occupied by the exposed fins between spacer structures 404. According to some embodiments, source or drain regions 802a/802b are epitaxially grown from the exposed semiconductor material at the ends of semiconductor layers 204. In some example embodiments, first source or drain regions 802a are p-channel source or drain regions (e.g., epitaxial silicon germanium with p-type dopants) and second source or drain regions 802b are n-channel source or drain regions (e.g., epitaxial silicon with n-type dopants).

According to some embodiments, a dielectric fill 804 is provided over source or drain regions 802a/802b. In some examples, dielectric fill 804 occupies a remaining volume within the source/drain trenches around and over portions of source or drain regions 802a/802b. Dielectric fill 804 may be any suitable dielectric material, such as silicon dioxide. In some examples, dielectric fill 804 extends up to and planar with a top surface of spacer structures 404 (e.g., following a polishing procedure).

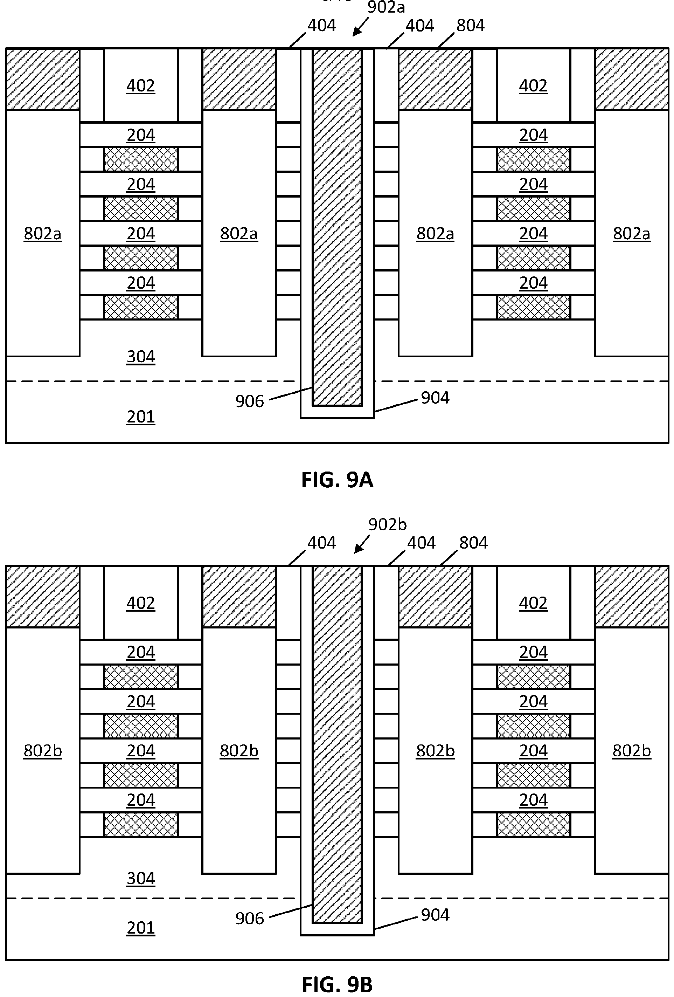

Figures 9A and 9B depict cross-section views of the structure shown in Figures 8A and 8B, respectively, following the formation of fin isolation structures 902a and 902b, according to some embodiments. A trench recess extending along the second direction between two semiconductor devices may first be formed along a gate trench (e.g., through sacrificial gate 402 and the layer stack of semiconductor layers 204 and sacrificial layers 202 between spacer structures 404). The trench recess may be formed by etching through the noted materials using a suitable anisotropic etching process, such as reactive ion etching (RIE). The trench recess extends along at least an entire height of the adjacent source or drain regions 802a/802b and, according to some embodiments, extends below a bottommost surface of the source or drain regions 802a/802b, such as at least 25 nm, at least 50 nm, at least 75 nm, or at least 100 nm below the bottommost surface of the source or drain regions. In some examples, the trench recess extends below a bottom surface of the dielectric fill (e.g., indicated by the dashed line) adjacent to subfin regions 304.

According to some embodiments, any number of trench recesses are filled with one or more dielectric materials to form fin isolation structures 902a and 902b. In an example, a dielectric liner 904 is deposited along all exposed surfaces of the trench recesses followed by a dielectric fill 906 deposited on dielectric liner 904. According to some embodiments, dielectric liner 904 is a high-k dielectric material, such as silicon nitride, and dielectric fill 906 is a low-k dielectric material, such as silicon dioxide. Dielectric liner 904 may have a thickness between about 3 nm and about 8 nm, about 5 nm and about 10 nm, or between about 5 nm and about 20 nm. The top surface of fin isolation structures 902a and 902b may be polished to be substantially coplanar with a top surface of the adjacent spacer structures 404.

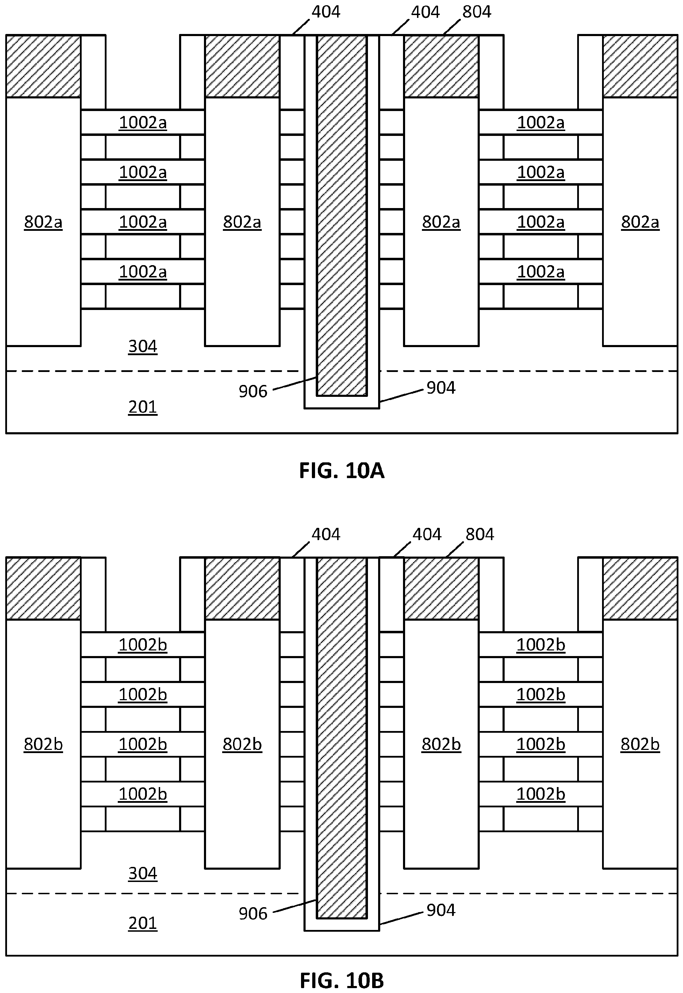

Figures 10A and 10B depict cross-section views of the structure shown in Figures 9A and 9B, respectively, following the removal of sacrificial gates 402 and sacrificial layers 202, according to some embodiments. In examples where gate masking layers are still present, they may be removed at this time. Once sacrificial gates 402 are removed, the remaining fin portions extending between spacer structures 404 are exposed.

In the example where the fins include alternating sacrificial layers 202 and semiconductor layers 204, sacrificial layers 202 are selectively removed to leave behind nanoribbons 1002a extending between first source or drain regions 802a and nanoribbons 1002b extending between second source or drain regions 802b. Each vertical set of nanoribbons 1002a/1002b represents the semiconductor region (also called channel region) of a different semiconductor device. It should be understood that nanoribbons 1002a/1002b may also be nanowires or nanosheets. Sacrificial gates 402 and sacrificial layers 202 may be removed using the same isotropic etching process or different isotropic etching processes.

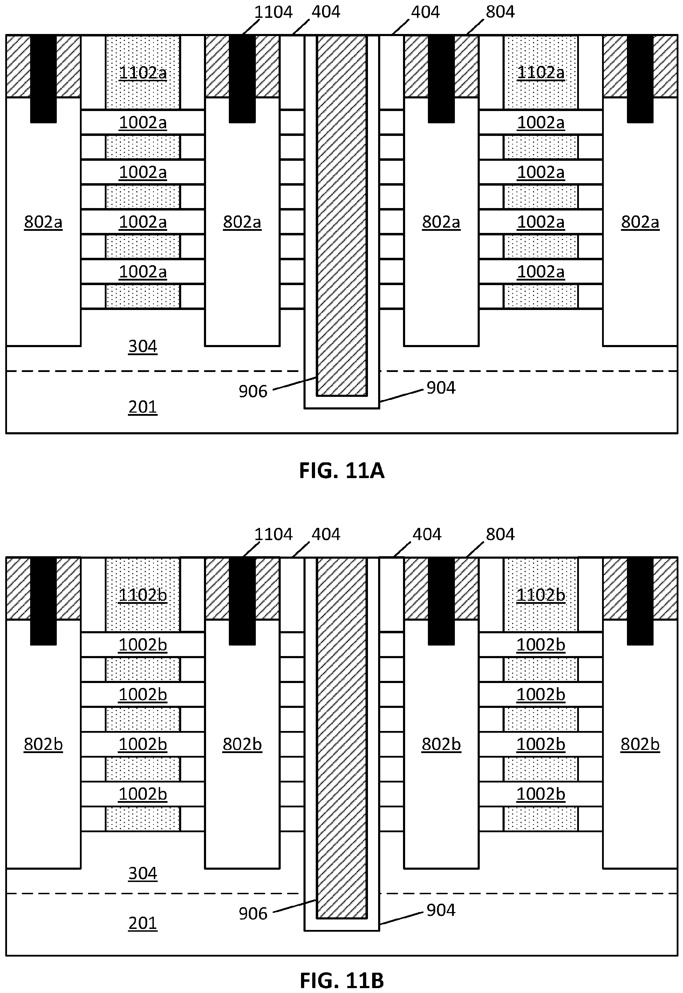

Figures 11A and 11B depict cross-section views of the structure shown in Figures 10A and 10B, respectively, following the formation of first gate structures 1102a around the suspended nanoribbons 1002a and second gate structures 1102b around the suspended nanoribbons 1002b, according to an embodiment of the present disclosure. As noted above, gate structures 1102a/1102b each include a gate dielectric and a gate electrode.

The gate dielectric may be conformally deposited around nanoribbons 1002a/1002b using any suitable deposition process, such as ALD. The gate dielectric may include any suitable dielectric (such as silicon dioxide, and/or a high-k dielectric material). Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. According to some embodiments, the gate dielectric is hafnium oxide with a thickness between about 1 nm and about 5 nm. In some embodiments, the gate dielectric may include one or more silicates (e.g., titanium silicate, tungsten silicate, niobium silicate, and silicates of other transition metals). The gate dielectric may be a multilayer structure, in some examples. For instance, the gate dielectric may include a first layer on nanoribbons 1002a/1002b, and a second layer on the first layer. The first layer can be, for instance, an oxide of the semiconductor layers (e.g., silicon dioxide) and the second layer can be a high-k dielectric material (e.g., hafnium oxide). In some embodiments, an annealing process may be carried out on the gate dielectric to improve its quality when a high-k dielectric material is used. In some embodiments, the high-k material can be nitridized to improve its aging resistance.

The gate electrode may be deposited over the gate dielectric and can be any standard or proprietary conductive material that may include any number of gate cuts. In some embodiments, the gate electrode includes doped polysilicon, a metal, or a metal alloy. Example suitable metals or metal alloys include aluminum, tungsten, cobalt, molybdenum, ruthenium, titanium, tantalum, copper, and carbides and nitrides thereof. The gate electrode may include, for instance, one or more workfunction layers, resistance-reducing layers, and/or barrier layers. In an example, first gate structures 1102a include p-type workfunction materials such as, for example, titanium nitride. In an example, second gate structures 1102b include n-type workfunction materials such as tungsten or titanium aluminum carbide.

According to some embodiments, source/drain contacts 1104 may be formed through dielectric fill 804 to contact the top surfaces of source or drain regions 802a/802b. Contacts 1104 may include any suitable conductive material, such as tungsten, cobalt, molybdenum, or ruthenium, for making electrical contact with the underlying source or drain regions 802a/802b.

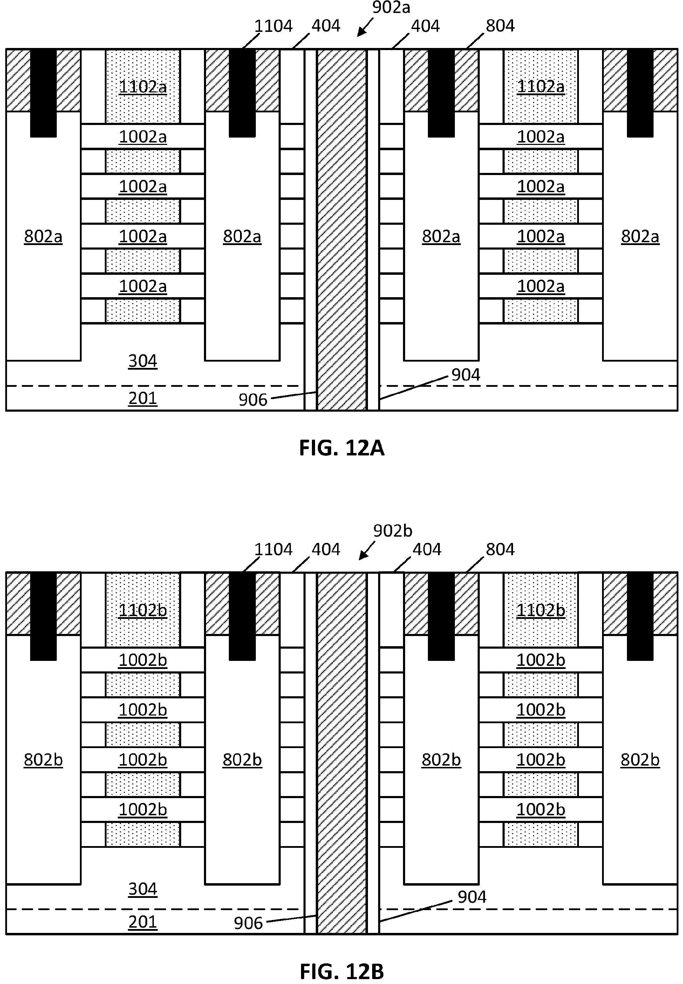

Figures 12A and 12B depict cross-section views of the structure shown in Figures 11A and 11B, respectively, following the removal of a backside portion of substrate 201, according to some embodiments. Any number of polishing, grinding, or etching processes may be used to remove the bulk portion of substrate 201. According to some embodiments, substrate 201 is removed until a bottom surface of fin isolation structures 902a and 902b is exposed. Accordingly, a portion of substrate 201 remains across the structure beneath subfin regions 304 and beneath the dielectric fill adjacent to subfin regions 304. As noted above, a bottom surface of the dielectric fill adjacent to subfin regions 304 is identified by the dashed line. The remaining portion of substrate 201 may have a thickness between about 5 nm and about 20 nm, between 15 nm and about 30 nm, or greater than 30 nm.

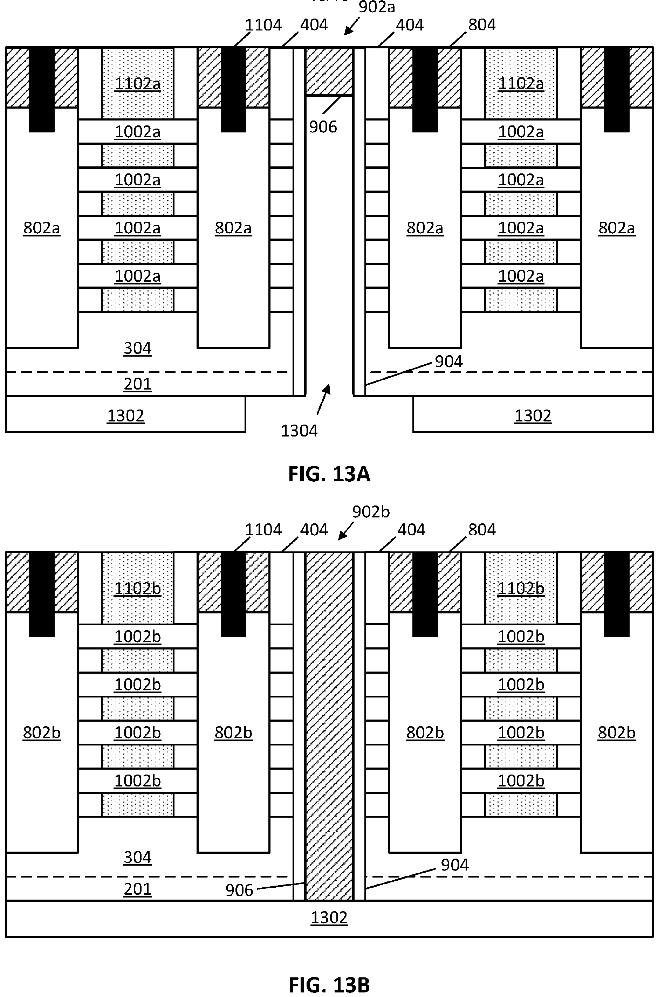

Figures 13A and 13B depict cross-section views of the structure shown in Figures 12A and 12B, respectively, following the backside recessing of dielectric fill 906 from first fin isolation structure 902a, according to some embodiments. A mask structure 1302 may be formed on the backside of the structure (e.g., on a bottom surface of the remaining portion of substrate 201) and patterned to expose the bottom surface of first fin isolation structure 902a while protecting the bottom surface of second fin isolation structure 902b. Any suitable lithography process may be used to pattern mask structure 1302. Mask structure 1302 may be any suitable photoresist or hard mask material, such as carbon hard mask (CHM).

According to some embodiments, an isotropic etching process may be used to recess the exposed dielectric fill 906 of first fin isolation structure 902a, thus forming a recess 1304. Note that the remaining portion of substrate 201 may protect the dielectric fill adjacent to subfin portion 304 during the recessing of dielectric fill 906. Dielectric fill 906 may be recessed to a final thickness of less than 50 nm, less than 40 nm, less than 30 nm, less than 20 nm, or less than 10 nm. According to some embodiments, dielectric fill 906 is recessed such that a bottommost surface of dielectric fill 906 is above a topmost surface of the adjacent source or drain regions 802a or above the topmost surface of nanoribbons 1002a. The recessed portion of dielectric fill 906 may be considered a plug (body) of dielectric material that is flanked by dielectric liner 904.

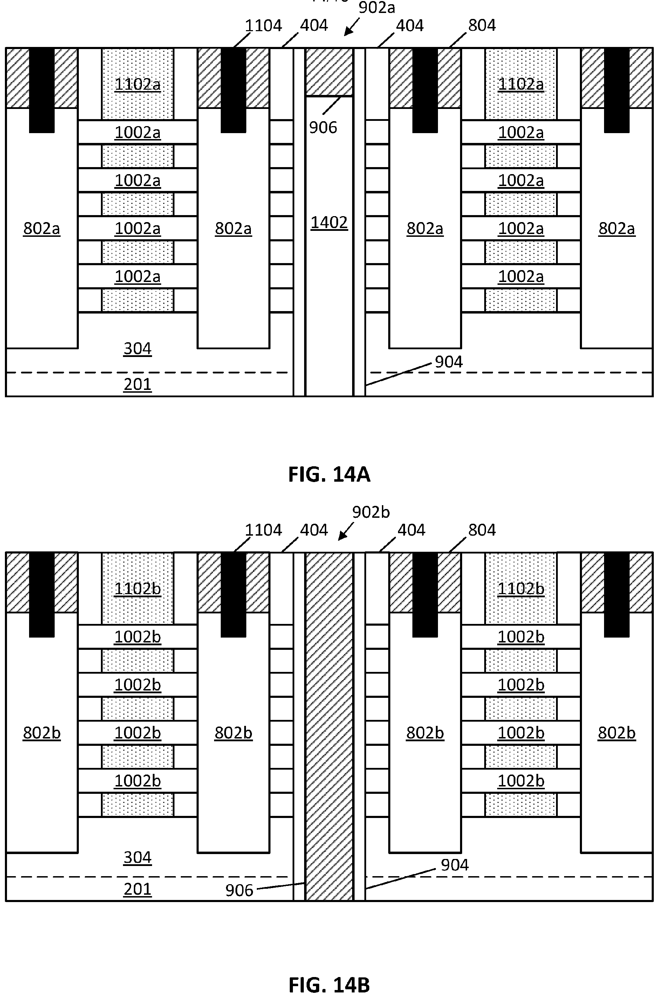

Figures 14A and 14B depict cross-section views of the structure shown in Figures 13A and 13B, respectively, following the removal of mask structure 1302 and formation of dielectric fill 1402 within recess 1304, according to some embodiments. Dielectric fill 1402 may be any suitable high-k dielectric material, such as silicon nitride. In some examples, dielectric fill 1402 is the same material as dielectric liner 904. Accordingly, a seam may or may not be visible between dielectric fill 1402 and dielectric liner 904. According to some embodiments, a bottom surface of dielectric fill 1402 is polished such that it is substantially coplanar with a bottom surface of substrate 201.

Figures 15A and 15B depict cross-section views of the structure shown in Figures 14A and 14B, respectively, following the removal of additional material from the backside and formation of backside dielectric structure 1502, according to some embodiments. The remainder of substrate 201 and subfin regions 304 may be removed from the backside using any suitable isotropic etching process that selectively removes the semiconductor material of substrate 201 and subfin regions 304. Afterwards, one or more dielectric materials may be deposited on the backside of the structure to form backside dielectric structure 1502. According to some embodiments, backside dielectric structure 1502 includes the dielectric material from the dielectric fill that had been adjacent to subfin regions 304. Backside dielectric structure 1502 may include any suitable dielectric material, such as silicon dioxide or silicon oxynitride. According to some embodiments, a bottom surface of backside dielectric structure 1502 is polished until a bottom surface of fin isolation structures 902a and 902b is exposed. According to some embodiments, fin isolation structures 902a and 902b extend below the bottommost surface of the adjacent source or drain regions 802a and 802b by at least 25 nm, at least 50 nm, at least 75, or at least 100 nm.

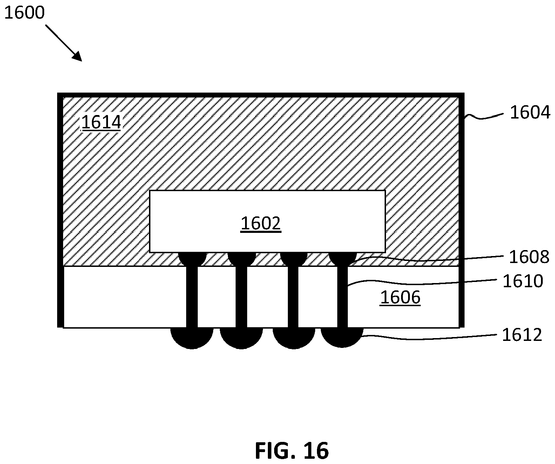

Figure 16 illustrates an example embodiment of a chip package 1600, in accordance with an embodiment of the present disclosure. As can be seen, chip package 1600 includes one or more dies 1602. One or more dies 1602 may include at least one integrated circuit having semiconductor devices, such as any of the semiconductor devices disclosed herein. One or more dies 1602 may include any other circuitry used to interface with other devices formed on the dies, or other devices connected to chip package 1600, in some example configurations.

As can be further seen, chip package 1600 includes a housing 1604 that is bonded to a package substrate 1606. The housing 1604 may be any standard or proprietary housing, and may provide, for example, electromagnetic shielding and environmental protection for the components of chip package 1600. The one or more dies 1602 may be conductively coupled to a package substrate 1606 using connections 1608, which may be implemented with any number of standard or proprietary connection mechanisms, such as solder bumps, ball grid array (BGA), pins, or wire bonds, to name a few examples. Package substrate 1606 may be any standard or proprietary package substrate, but in some cases includes a dielectric material having conductive pathways (e.g., including conductive vias and lines) extending through the dielectric material between the faces of package substrate 1606, or between different locations on each face. In some embodiments, package substrate 1606 may have a thickness less than 1 millimeter (e.g., between 0.1 millimeters and 0.5 millimeters), although any number of package geometries can be used. Additional conductive contacts 1612 may be disposed at an opposite face of package substrate 1606 for conductively contacting, for instance, a printed circuit board (PCB). One or more vias 1610 extend through a thickness of package substrate 1606 to provide conductive pathways between one or more of connections 1608 to one or more of contacts 1612. Vias 1610 are illustrated as single straight columns through package substrate 1606 for ease of illustration, although other configurations can be used (e.g., damascene, dual damascene, through-silicon via, or an interconnect structure that meanders through the thickness of substrate 1606 to contact one or more intermediate locations therein). In still other embodiments, vias 1610 are fabricated by multiple smaller stacked vias, or are staggered at different locations across package substrate 1606. In the illustrated embodiment, contacts 1612 are solder balls (e.g., for bump-based connections or a ball grid array arrangement), but any suitable package bonding mechanism may be used (e.g., pins in a pin grid array arrangement or lands in a land grid array arrangement). In some embodiments, a solder resist is disposed between contacts 1612, to inhibit shorting.

In some embodiments, a mold material 1614 may be disposed around the one or more dies 1602 included within housing 1604 (e.g., between dies 1602 and package substrate 1606 as an underfill material, as well as between dies 1602 and housing 1604 as an overfill material). Although the dimensions and qualities of the mold material 1614 can vary from one embodiment to the next, in some embodiments, a thickness of mold material 1614 is less than 1 millimeter. Example materials that may be used for mold material 1614 include epoxy mold materials, as suitable. In some cases, the mold material 1614 is thermally conductive, in addition to being electrically insulating.

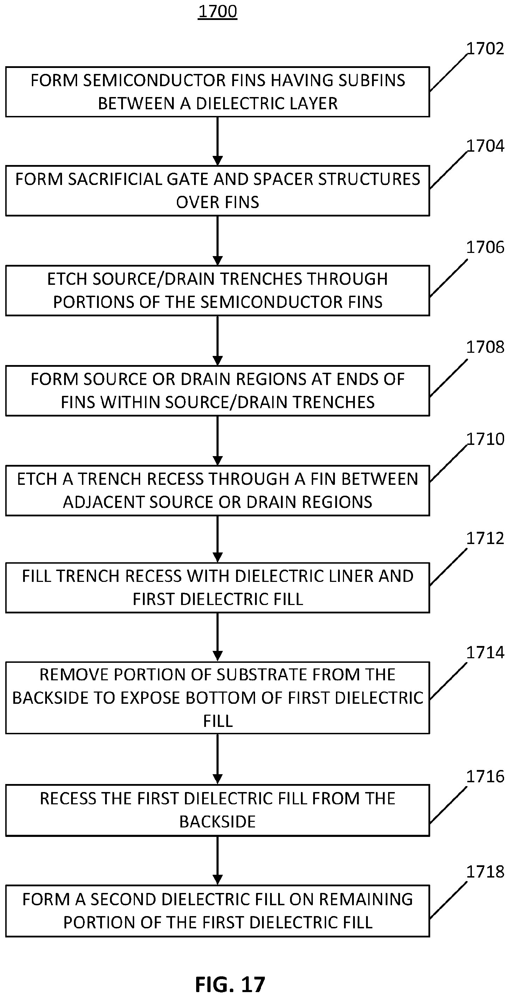

Figure 17 is a flow chart of a method 1700 for forming at least a portion of an integrated circuit, according to an embodiment. Various operations of method 1700 may be illustrated in Figures 2A- 15A and 2B - 15B. However, the correlation of the various operations of method 1700 to the specific components illustrated in the aforementioned figures is not intended to imply any structural and/or use limitations. Rather, the aforementioned figures provide one example embodiment of method 1700. Other operations may be performed before, during, or after any of the operations of method 1700. For example, method 1700 does not explicitly describe various standard processes that are usually performed to form transistor structures. Some of the operations of method 1700 may be performed in a different order than the illustrated order.

Method 1700 begins with operation 1702 where a plurality of parallel semiconductor fins are formed, according to some embodiments. The semiconductor material in the fins may be formed from a substrate such that the fins are an integral part of the substrate (e.g., etched from a bulk silicon substrate). Alternatively, the fins can be formed of material deposited onto an underlying substrate. In one such example case, a blanket layer of SiGe can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of nanowires and nanoribbons during a gate forming process where one type of the alternating layers are selectively etched away so as to liberate the other type of alternating layers within the channel region, so that a gate-all-around (GAA) process can then be carried out. Again, the alternating layers can be blanket deposited and then etched into fins, or deposited into fin-shaped trenches, according to some examples. The fins may also include a cap structure over each fin that is used to define the locations of the fins during, for example, an RIE process. The cap structure may be a dielectric material, such as silicon nitride.

According to some embodiments, a dielectric fill is formed around subfin portions of the one or more fins. In some embodiments, the dielectric fill extends between each pair of adjacent parallel fins and runs lengthwise in the same direction as the fins. In some embodiments, the anisotropic etching process that forms the fins also etches into a portion of the substrate and the dielectric fill may be formed within the recessed portions of the substrate. Accordingly, the dielectric fill acts as shallow trench isolation (STI) between adjacent fins. The dielectric fill may be any suitable dielectric material, such as silicon dioxide. Lower portions of the fins adjacent to the dielectric fill may be identified as the subfins.

Method 1700 continues with operation 1704 where sacrificial gates are formed over the fins. The sacrificial gates may be patterned using gate masking layers in strips that run orthogonally over the fins and parallel to one another (e.g., forming a cross-hatch pattern). The gate masking layers may be any suitable hard mask material, such as CHM or silicon nitride. The sacrificial gates themselves may be formed from any suitable material that can be selectively removed at a later time without damaging the semiconductor material of the fins. In one example, the sacrificial gates include polysilicon.

According to some embodiments, spacer structures are also formed on sidewalls of at least the sacrificial gates. The spacer structures may be deposited and then etched back such that the spacer structures remain mostly only on sidewalls of any exposed structures. In some cases, spacer structures may also be formed along sidewalls of the exposed fins running orthogonally between the strips of sacrificial gates. According to some embodiments, the spacer structures may be any suitable dielectric material, such as silicon nitride or silicon oxynitride.

Method 1700 continues with operation 1706 where exposed portions of the fins are removed to form source/drain trenches. Any exposed portions of the fins not covered by the sacrificial gates or spacer structures may be removed using any anisotropic etching process, such as reactive ion etching (RIE). Sacrificial layers of the fins may be recessed (e.g., via isotropic etch process) followed by deposition of internal spacers (e.g., silicon nitride), as described above.

Method 1700 continues with operation 1708 where source or drain regions are formed at opposite ends of the fins within the source/drain trenches. The source or drain regions may be formed in the areas that had been previously occupied by the exposed fins between the spacer structures. According to some embodiments, the source or drain regions are epitaxially grown from the exposed semiconductor material of the fins (or nanoribbons, nanowires or nanosheets, as the case may be) along the exterior walls of the spacer structures. In some example embodiments, the source or drain regions are NMOS source or drain regions (e.g., epitaxial silicon with n-type dopants) or PMOS source or drain regions (e.g., epitaxial SiGe with p-type dopants). A dielectric fill may be formed between and over the source or drain regions along a given source/drain trench. The dielectric fill may be any suitable dielectric material, such as silicon dioxide. In some examples, the dielectric fill extends over the source or drain regions up to and planar with a top surface of the spacer structures. The dielectric fill also acts as an electrical insulator between adjacent source or drain regions, although some adjacent source or drain regions may have merged together during their growth.

Method 1700 continues with operation 1710 where a trench recess is formed through a fin between adjacent source or drain regions. According to some embodiments, the trench recess extends along the second direction between semiconductor devices having colinearly aligned semiconductor regions to electrically isolate the semiconductor devices. An RIE process may be used to form the trench recess through the semiconductor material of the fin and also through the sacrificial gate material (as the trench recess extends along the gate trench between adjacent spacer structures). Accordingly, the trench recess extends at least along the entire height of the adjacent fins or at least along the entire height of the adjacent source or drain regions.

According to some embodiments, the trench recess is etched relatively deep through the structure such that the trench recess extends at least below a bottommost surface of the source or drain regions, such as at least 25 nm, at least 50 nm, at least 75 nm, or at least 100 nm below the bottommost surface of the source or drain regions. In some examples, the trench recess extends below a bottom surface of the dielectric fill around the subfin portions of the fins.

Method 1700 continues with operation 1712 where the trench recess is filled with one or more dielectric materials to form a fin isolation structure. According to some embodiments, a dielectric liner is deposited on the surfaces of the trench recess followed by a first dielectric fill on the dielectric liner. According to some embodiments, the dielectric liner is a high-k dielectric material, such as silicon nitride, and the dielectric fill is a low-k dielectric material, such as silicon dioxide. The dielectric liner may have a thickness between about 3 nm and about 8 nm, about 5 nm and about 10 nm, or between about 5 nm and about 20 nm. The top surface of the deposited dielectric fill may be polished to be substantially coplanar with a top surface of the adjacent spacer structures. Any suitable deposition process may be used to form the dielectric liner and first dielectric fill. In some examples, the dielectric liner is formed using ALD to conformally deposit on the surfaces of the trench recess. The dielectric fill may be deposited using any of CVD, PECVD, ALD, or PVD.

Method 1700 continues with operation 1714 where a portion of the substrate is removed from the backside to expose a bottom surface of the fin isolation structure (e.g., a bottom surface of at least the dielectric fill of the fin isolation structure). Any number of polishing, grinding, or etching processes may be used to remove the bulk portion of the substrate beneath the semiconductor devices. According to some embodiments, a portion of the substrate remains across the structure beneath the subfin regions and beneath the dielectric fill adjacent to the subfin regions. The remaining portion of the substrate may have a thickness between about 5 nm and about 20 nm, between 15 nm and about 30 nm, or greater than 30 nm.

Method 1700 continues with operation 1716 where the first dielectric fill of the fin isolation structure is recessed from the backside. A mask structure may be formed on the backside of the structure (e.g., on a bottom surface of the remaining portion of substrate) and patterned to expose the bottom surface of fin isolation structure.

According to some embodiments, an isotropic etching process may be used to recess the exposed first dielectric fill of the fin isolation structure from the backside. The first dielectric fill may be recessed to a final thickness of less than 50 nm, less than 40 nm, less than 30 nm, less than 20 nm, or less than 10 nm. According to some embodiments, the first dielectric fill is recessed such that a bottommost surface of the first dielectric fill is above a topmost surface of the adjacent source or drain regions.

Method 1700 continues with operation 1718 where a second dielectric fill is formed on the first dielectric fill within the trench recess. According to some embodiments, the second dielectric fill may be any suitable high-k dielectric material, such as silicon nitride. In some examples, the second dielectric fill has the same material composition as the dielectric liner. Accordingly, a seam mayor may not be visible between the second dielectric fill and the dielectric liner. According to some embodiments, the second dielectric fill substantially fills the remaining volume of the trench recess following the recessing of the first dielectric fill. According to some embodiments, a bottom surface of the second dielectric fill is polished such that it is substantially coplanar with a bottom surface of the remaining portion of the substrate.

### Example System

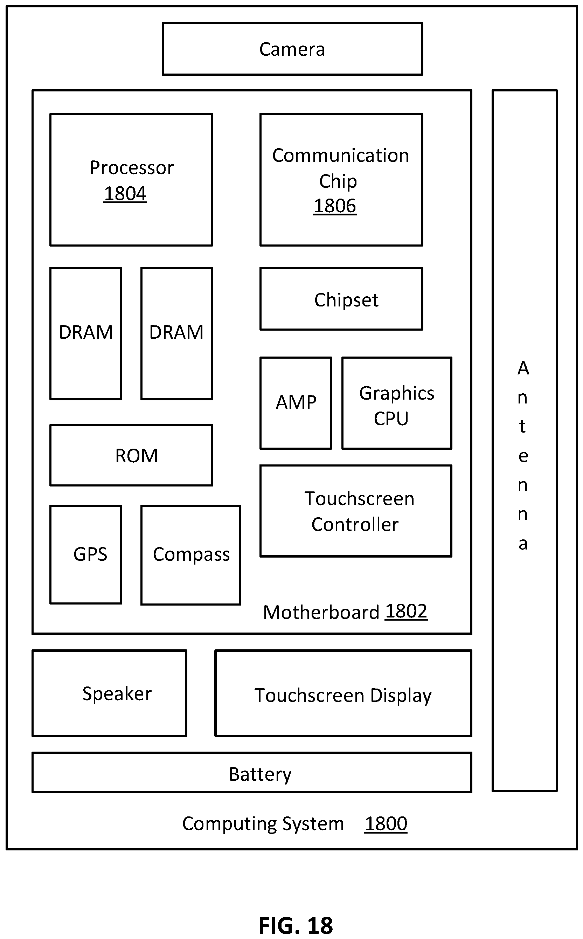

FIG. 18 is an example computing system implemented with one or more of the integrated circuit structures as disclosed herein, in accordance with some embodiments of the present disclosure. As can be seen, the computing system 1800 houses a motherboard 1802. The motherboard 1802 may include a number of components, including, but not limited to, a processor 1804 and at least one communication chip 1806, each of which can be physically and electrically coupled to the motherboard 1802, or otherwise integrated therein. As will be appreciated, the motherboard 1802 may be, for example, any printed circuit board (PCB), whether a main board, a daughterboard mounted on a main board, or the only board of system 1800, etc.

Depending on its applications, computing system 1800 may include one or more other components that may or may not be physically and electrically coupled to the motherboard 1802. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1800 may include one or more integrated circuit structures or devices configured in accordance with an example embodiment (e.g., a module including an integrated circuit configured with backside-patterned fin isolation structures between semiconductor devices, as variously provided herein). In some embodiments, multiple functions can be integrated into one or more chips (e.g., for instance, note that the communication chip 1806 can be part of or otherwise integrated into the processor 1804).

The communication chip 1806 enables wireless communications for the transfer of data to and from the computing system 1800. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1806 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1800 may include a plurality of communication chips 1806. For instance, a first communication chip 1806 may be dedicated to shorter range wireless communications such as Wi-Fi and Bluetooth and a second communication chip 1806 may be dedicated to longer range wireless communications such as GPS, EDGE, GPRS, CDMA, WiMAX, LTE, Ev-DO, and others.

The processor 1804 of the computing system 1800 includes an integrated circuit die packaged within the processor 1804. In some embodiments, the integrated circuit die of the processor includes onboard circuitry that is implemented with one or more semiconductor devices as variously described herein. The term "processor" may refer to any device or portion of a device that processes, for instance, electronic data from registers and/or memory to transform that electronic data into other electronic data that may be stored in registers and/or memory.

The communication chip 1806 also may include an integrated circuit die packaged within the communication chip 1806. In accordance with some such example embodiments, the integrated circuit die of the communication chip includes one or more semiconductor devices as variously described herein. As will be appreciated in light of this disclosure, note that multistandard wireless capability may be integrated directly into the processor 1804 (e.g., where functionality of any chips 1806 is integrated into processor 1804, rather than having separate communication chips). Further note that processor 1804 may be a chip set having such wireless capability. In short, any number of processor 1804 and/or communication chips 1806 can be used. Likewise, any one chip or chip set can have multiple functions integrated therein.

In various implementations, the computing system 1800 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device that processes data or employs one or more integrated circuit structures or devices formed using the disclosed techniques, as variously described herein.

It will be appreciated that in some embodiments, the various components of the computing system 1800 may be combined or integrated in a system-on-a-chip (SoC) architecture. In some embodiments, the components may be hardware components, firmware components, software components or any suitable combination of hardware, firmware or software.

### Further Example Embodiments

The following examples pertain to further embodiments, from which numerous permutations and configurations will be apparent.

Example 1 is an integrated circuit that includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, and a dielectric structure extending in the second direction between the first source or drain region and the second source or drain region, and extending in a third direction along an entire height of the first source or drain region and the second source or drain region. The second semiconductor region is aligned with the first semiconductor region along the first direction. The dielectric structure extends to a depth below a bottommost surface of the first and second source or drain regions.

Example 2 includes the integrated circuit of Example 1, wherein the dielectric structure comprises a first dielectric material and a second dielectric material.

Example 3 includes the integrated circuit of Example 2, wherein the second dielectric material fills a core of the dielectric structure and extends along an entire height of the dielectric structure in the third direction, and the first dielectric material wraps around sides of the second dielectric material.

Example 4 includes the integrated circuit of Example 3, wherein the first dielectric material comprises silicon and nitrogen, and the second dielectric material comprises silicon and oxygen.

Example 5 includes the integrated circuit of Example 3 or 4, wherein the first dielectric material has a dielectric constant of 6.0 or more, and the second dielectric material has a dielectric constant of less than 5.0.

Example 6 includes the integrated circuit of any one of Examples 3-5, wherein the first source or drain region and the second source or drain region are n-type regions.

Example 7 includes the integrated circuit of Example 2, wherein the second dielectric material is a body of material having a bottommost surface that is above both a topmost surface of the first source or drain region and a topmost surface of the second source or drain region, and the first dielectric material wraps around sides of the second dielectric material and fills a region below the second dielectric material.

Example 8 includes the integrated circuit of Example 7, wherein the first dielectric material comprises silicon and nitrogen, and the second dielectric material comprises silicon and oxygen.

Example 9 includes the integrated circuit of Example 7 or 8, wherein the first source or drain region and the second source or drain region are p-type regions.

Example 10 includes the integrated circuit of any one of Examples 1-9, wherein the first semiconductor region comprises a plurality of first semiconductor nanoribbons, and the second semiconductor region comprises a plurality of second semiconductor nanoribbons.

Example 11 includes the integrated circuit of Example 10, wherein the plurality of first semiconductor nanoribbons and the plurality of second semiconductor nanoribbons comprise germanium, silicon, or a combination thereof.

Example 12 includes the integrated circuit of any one of Examples 1-11, further comprising a third semiconductor region extending between the dielectric structure and the first source or drain region along the first direction and a fourth semiconductor region extending between the dielectric structure and the second source or drain region along the first direction.

Example 13 includes the integrated circuit of Example 12, wherein the third and fourth semiconductor regions are aligned with the first and second semiconductor regions along the first direction.

Example 14 includes the integrated circuit of any one of Examples 1-13, wherein the dielectric structure extends at least 50 nm below the bottommost surface of the first and second source or drain regions.

Example 15 is a printed circuit board comprising the integrated circuit of any one of Examples 1-14.

Example 16 is an electronic device that includes a chip package having one or more dies. At least one of the one or more dies includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, and a dielectric structure extending in the second direction between the first source or drain region and the second source or drain region, and extending in a third direction along an entire height of the first source or drain region and the second source or drain region. The second semiconductor region is aligned with the first semiconductor region along the first direction. The first and second source or drain regions each extend to a first depth below a bottommost surface of the first and second gate structures, and the dielectric structure extends to a second depth below the bottommost surface of the first and second gate structures. The second depth is greater than the first depth.

Example 17 includes the electronic device of Example 16, wherein the dielectric structure comprises a first dielectric material and a second dielectric material.

Example 18 includes the electronic device of Example 17, wherein the second dielectric material fills a core of the dielectric structure and the first dielectric material wraps around the second dielectric material.

Example 19 includes the electronic device of Example 18, wherein the first dielectric material comprises silicon and nitrogen, and the second dielectric material comprises silicon and oxygen.

Example 20 includes the electronic device of Example 18 or 19, wherein the first source or drain region and the second source or drain region are n-type regions.

Example 21 includes the electronic device of Example 17, wherein the second dielectric material is a plug of material above both a topmost surface of the first source or drain region and a topmost surface of the second source or drain region, and the first dielectric material wraps around the second dielectric material and fills a region below the second dielectric material.

Example 22 includes the electronic device of Example 21, wherein the first dielectric material comprises silicon and nitrogen, and the second dielectric material comprises silicon and oxygen.

Example 23 includes the electronic device of Example 21 or 22, wherein the first source or drain region and the second source or drain region are p-type regions.

Example 24 includes the electronic device of any one of Examples 16-23, wherein the first semiconductor region comprises a plurality of first semiconductor nanoribbons, and the second semiconductor region comprises a plurality of second semiconductor nanoribbons.

Example 25 includes the electronic device of Example 24, wherein the plurality of first semiconductor nanoribbons and the plurality of second semiconductor nanoribbons comprise germanium, silicon, or a combination thereof.

Example 26 includes the electronic device of any one of Examples 16-25, further comprising a third semiconductor region extending between the dielectric structure and the first source or drain region along the first direction and a fourth semiconductor region extending between the dielectric structure and the second source or drain region along the first direction.

Example 27 includes the electronic device of Example 26, wherein the third and fourth semiconductor regions are aligned with the first and second semiconductor regions along the first direction.

Example 28 includes the electronic device of any one of Examples 16-27, wherein the second depth is at least 50 nm greater than the first depth.

Example 29 includes the electronic device of any one of Examples 16-28, further comprising a printed circuit board, wherein the chip package is coupled to the printed circuit board.

Example 30 is a method of forming an integrated circuit. The method includes forming fins comprising semiconductor material, the fins extending above a substrate and each extending in line with one another along a first direction, forming a dielectric layer around a base portion of the fins, forming source or drain regions at ends of each of the fins, forming a recess through a given fin, wherein the recess extends below a bottom surface of the dielectric layer, forming a first dielectric material on sidewalls of the recess, forming a second dielectric material on the first dielectric material within the recess, the first and second dielectric materials together forming a dielectric structure, forming gate electrodes extending over the semiconductor material of the fins in a second direction different from the first direction, removing a portion of the substrate from a backside of the integrated circuit and exposing a bottom surface of the dielectric structure, recessing or removing the second dielectric material from the backside to form a backside recess, and filling the backside recess with a third dielectric material.

Example 31 includes the method of Example 30, wherein the third dielectric material is the same as the first dielectric material.

Example 32 includes the method of Example 30 or 31, further comprising removing a remaining portion of the substrate from the backside, and forming a dielectric fill in place of the remaining portion of the substrate.

Example 33 includes the method of any one of Examples 30-32, wherein the given fin extends between given source or drain regions and the given source or drain regions are p-type regions.

Example 34 includes the method of any one of Examples 30-33, wherein the first dielectric material comprises silicon and nitrogen, and the second dielectric material comprises silicon and oxygen.

Example 35 is an integrated circuit that includes a first semiconductor device having a first semiconductor region extending in a first direction from a first source or drain region and a first gate structure extending in a second direction over the first semiconductor region, a second semiconductor device having a second semiconductor region extending in the first direction from a second source or drain region and a second gate structure extending in the second direction over the second semiconductor region, and a dielectric structure extending in the second direction between the first source or drain region and the second source or drain region, and extending in a third direction along a height of the first source or drain region and the second source or drain region. The second semiconductor region is aligned with the first semiconductor region along the first direction. The dielectric structure includes a first dielectric material and a second dielectric material on the first dielectric material. The second dielectric material is a plug of material above both a topmost surface of the first source or drain region and a topmost surface of the second source or drain region. The first dielectric material wraps around the second dielectric material and fills a region of the dielectric structure below the second dielectric material.

Example 36 includes the integrated circuit of Example 35, wherein the first dielectric material comprises silicon and nitrogen, and the second dielectric material comprises silicon and oxygen.

Example 37 includes the integrated circuit of Example 35 or 36, wherein the first source or drain region and the second source or drain region are p-type regions.

Example 38 includes the integrated circuit of any one of Examples 35-37, wherein the first semiconductor region comprises a plurality of first semiconductor nanoribbons, and the second semiconductor region comprises a plurality of second semiconductor nanoribbons.

Example 39 includes the integrated circuit of Example 38, wherein the plurality of first semiconductor nanoribbons and the plurality of second semiconductor nanoribbons comprise germanium, silicon, or a combination thereof.

Example 40 includes the integrated circuit of any one of Examples 35-39, further comprising a third semiconductor region extending between the dielectric structure and the first source or drain region along the first direction and a fourth semiconductor region extending between the dielectric structure and the second source or drain region along the first direction.

Example 41 includes the integrated circuit of Example 40, wherein the third and fourth semiconductor regions are aligned with the first and second semiconductor regions along the first direction.

Example 42 includes the integrated circuit of any one of Examples 35-41, wherein the dielectric structure extends at least 50 nm below the bottommost surface of the first and second source or drain regions.

Example 43 is a printed circuit board comprising the integrated circuit of any one of Examples 35-42.

The foregoing description of the embodiments of the disclosure has been presented for the purposes of illustration and description. It is not intended to be exhaustive or to limit the disclosure to the precise forms disclosed. Many modifications and variations are possible in light of this disclosure. It is intended that the scope of the disclosure be limited not by this detailed description, but rather by the claims appended hereto.

## Claims

1. An integrated circuit comprising:
a first semiconductor device having a first semiconductor region extending in a first direction from a first source or drain region, and a first gate structure extending in a second direction over the first semiconductor region;
a second semiconductor device having a second semiconductor region extending in the first direction from a second source or drain region, and a second gate structure extending in the second direction over the second semiconductor region, wherein the second semiconductor region is aligned with the first semiconductor region along the first direction; and
a dielectric structure extending in the second direction between the first source or drain region and the second source or drain region, and extending in a third direction along an entire height of the first source or drain region and the second source or drain region, wherein the dielectric structure extends to a depth below a bottommost surface of the first and second source or drain regions.

2. The integrated circuit of claim 1, wherein the dielectric structure comprises a first dielectric material and a second dielectric material.

3. The integrated circuit of claim 2, wherein the second dielectric material fills a core of the dielectric structure and extends along an entire height of the dielectric structure in the third direction, and the first dielectric material wraps around sides of the second dielectric material.

4. The integrated circuit of claim 3, wherein the first dielectric material comprises silicon and nitrogen, and the second dielectric material comprises silicon and oxygen.

5. The integrated circuit of claim 3 or 4, wherein the first dielectric material has a dielectric constant of 6.0 or more, and the second dielectric material has a dielectric constant of less than 5.0.

6. The integrated circuit of any one of claims 3 through 5, wherein the first source or drain region and the second source or drain region are n-type regions.

7. The integrated circuit of claim 2, wherein the second dielectric material is a body of material having a bottommost surface that is above both a topmost surface of the first source or drain region and a topmost surface of the second source or drain region, and the first dielectric material wraps around sides of the second dielectric material and fills a region below the second dielectric material.

8. The integrated circuit of claim 7, wherein the first dielectric material comprises silicon and nitrogen, and the second dielectric material comprises silicon and oxygen.

9. The integrated circuit of claim 7 or 8, wherein the first source or drain region and the second source or drain region are p-type regions.

10. The integrated circuit of any one of claims 1 through 9, wherein the first semiconductor region comprises a plurality of first semiconductor nanoribbons, and the second semiconductor region comprises a plurality of second semiconductor nanoribbons.

11. The integrated circuit of claim 10, wherein the plurality of first semiconductor nanoribbons and the plurality of second semiconductor nanoribbons comprise germanium, silicon, or a combination thereof.

12. The integrated circuit of any one of claims 1 through 11, further comprising a third semiconductor region extending between the dielectric structure and the first source or drain region along the first direction and a fourth semiconductor region extending between the dielectric structure and the second source or drain region along the first direction.

13. The integrated circuit of claim 12, wherein the third and fourth semiconductor regions are aligned with the first and second semiconductor regions along the first direction.

14. The integrated circuit of any one of claims 1 through 13, wherein the dielectric structure extends at least 50 nm below the bottommost surface of the first and second source or drain regions.

15. A printed circuit board comprising the integrated circuit of any one of claims 1 through 14.
